Europäisches Patentamt

European Patent Office

Office européen des brevets

(19)

(11) Publication number: **0018116**
A1

(12) **EUROPEAN PATENT APPLICATION**

(21) Application number: 80300985.1

(22) Date of filing: 28.03.80

(51) Int. Cl.³: **G 01 G 19/00,** H 01 R 23/70, G 11 C 17/00

(30) Priority: 13.04.79 US 29968

(43) Date of publication of application: 29.10.80 Bulletin 80/22

(84) Designated Contracting States: CH DE FR GB

(71) Applicant: PITNEY BOWES INC., Walter H. Wheeler Jr. Drive, Stamford, Connecticut 06904 (US)

(72) Inventor: Dlugos, Daniel Frank, 12, Twin Brooks Drive, Huntington Connecticut 06484 (US)

(74) Representative: Cook, Anthony John et al, D. YOUNG & CO. 10, Staple Inn, London, WC1V 7RD (GB)

(54) Postal data memory.

(57) A postal data memory comprises a printed circuit card (34) having thereon a single i/c read only memory device. The latter is directly connected to contacts (42) at an edge of the card. A slot (43) is located between selected contacts and there is a lever (37) pivoted to the card at the opposite edge.

Such a memory is disposable and can be easily exchanged by unskilled persons.

0018116

1.

<u>POSTAL DATA MEMORY</u>

This invention relates to user exchangeable memories for electronically operative equipment, and is particularly directed to the provision of user exchangeable memories for updating postal data in an electronic postal weighing scale.

In one form of postal weighing scale system, means are provided for calculating the postage that must be applied to a package to be mailed. Thus, it is well-known that the postage required is dependent upon various factors such as the weight of the package, the distance that the package is to be sent, and the class of the mailing to be effected. Variable rates also exist with respect to packages to be sent by other than government operated postal systems, such as the United Parcel Service in the United States of America. It is further known that, from time to time, changes are made in the rates for mailing such packages, whereby means must be provided for bringing the memories of such calculating systems up-to-date.

When the required calculation data is changed, it is necessary to rapidly update a very large number of pieces of apparatus, a requirement that can be effectively met only by providing a system wherein the user or possesser of the apparatus can effect the necessary change. For example, in our U.S. Patent Specification No. 4 084 242, Conti, it is suggested that an electronic postage weighing scale be provided with a drawer which the user can pull out. The user can then replace memory chips on a circuit board in the drawer by up-to-date memory chips.

While such a system is satisfactory for some changes that can be readily effected, it assumes a degree of dexterity on the part of the user which may not be realistic, and it also does not avoid confusion that may result in the chips that must be replaced. Thus, integrated circuit chips are frequently in packages known as dual-in-line packages (DIP's) having a plurality of fine terminals extending from each of a pair of edges thereof. The terminals may easily be bent, so that insertion of substitute integrated circuits may be difficult for some persons. Further, the dual-in-line packages are normally supplied with standard terminal configurations. Hence a user could easily insert a substitute package in the wrong socket on the circuit board.

In accordance with the invention, there is provided a user exchangeable postal data memory for a postal weighing scale comprising a printed circuit card characterised in that it has a pair of parallel guide edges joined by and substantially perpendicular to a contact edge (38), spaced apart parallel conductive contacts (42) extending on at least one surface of said card from said contact edge, and an integrated circuit read only memory (50) mounted on said card, conductive means (51) on at least one surface of said card for connecting said memory to said contacts, a lever element (37) pivoted to said card adjacent the edge (46) thereof opposite said contact edge, said lever element having a width greater than the thickness of said card, and, in a manner known per se, at least one slot (43) in said card extending between a pair of adjacent contacts at said contact edge.

As particularly disclosed and illustrated herein, a printed circuit board has a plurality of contacts along one end thereof, a pull-out lever hinged to the opposite edge, and a single read only memory integrated circuit device mounted on the card and connected to the contacts by way of suitable printed circuit conductors on the board.   The card is thereby configured to avoid the necessity for inexperienced personnel to directly handle circuit components, while still minimizing the cost of replacement of components necessitated by the occasional changing of data of the look-up tables required in systems of this kind.   A slot may be provided between the contacts of the cards in order to avoid misinsertion of the cards, and location indicia may be provided on the levers,

so that the user can tell at a glance, by reference to the indicia, if an error has been made in the insertion of any of the cards in the apparatus.

The invention will be better understood from the following particular and non-limiting description given with reference to the accompanying drawings, wherein:-

Figure 1 is a perspective view of a postal weighing system which may be employed in combination with an example of the printed circuit cards according to the invention;

Figure 2 is a perspective enlarged view of a rack for receiving printed circuit cards in accordance with the invention, the view also showing several of the printed circuit cards inserted in the rack and one card

readyfor insertion;

Figure 3 is a perspective view of one embodiment of a printed circuit card in accordance with the invention;

Figure 4 is a view of the printed circuit card of Figure 3 taken from the right hand edge;

Figure 5 is a top view of the printed circuit card of Figure 3;

Figure 6 is a view of one side of the printed circuit card on

Figure 3;

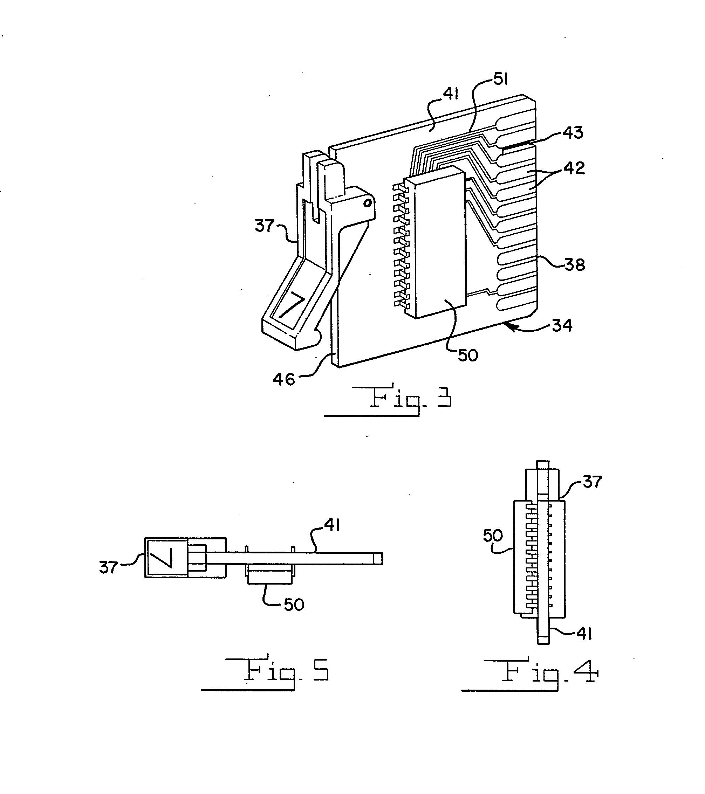

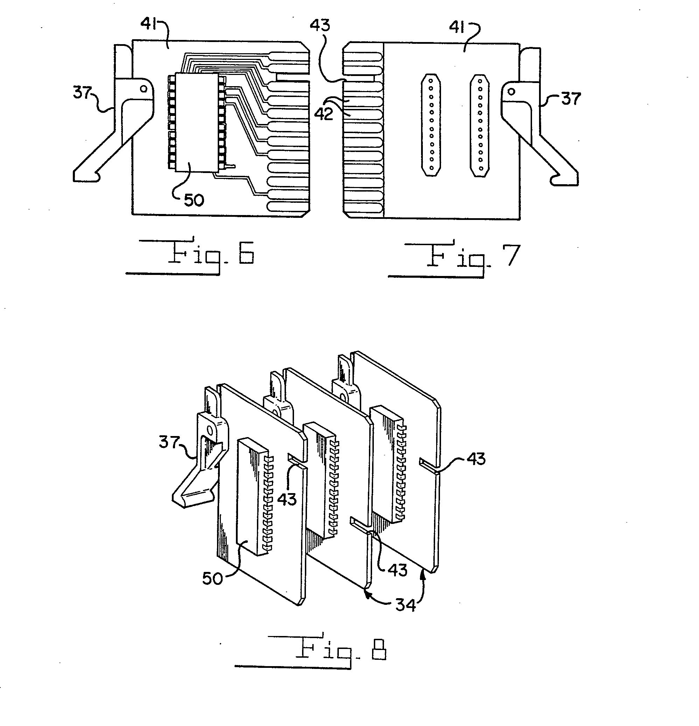

Figure 7 is a view of the other side of the printed circuit card of Figure 3; and

Figure 8 is a perspective view of a set of cards in accordance with the invention, to illustrate a further feature thereof.

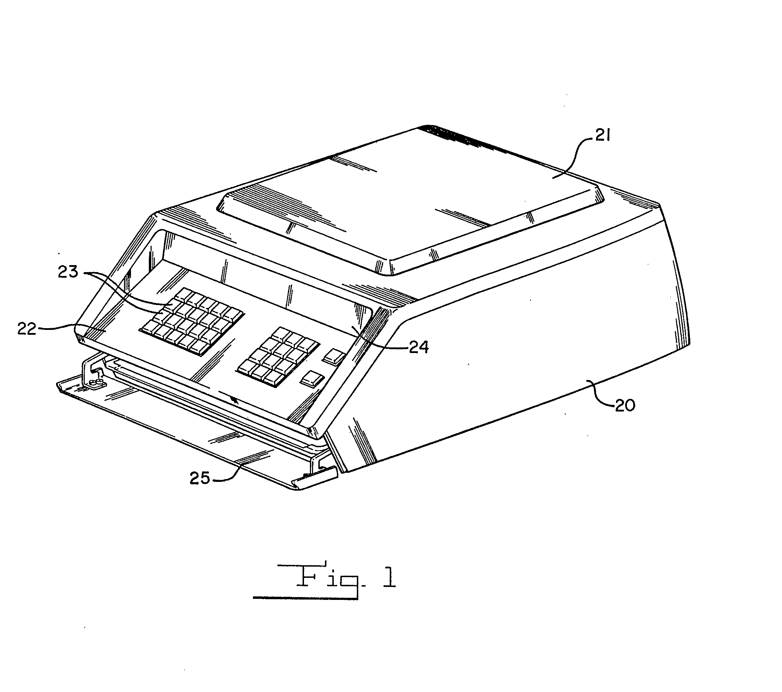

Figure 1 illustrates a postal weighing scale of the type with which the present invention is concerned.    The scale includes a housing 20 having a weighing platform or pan 21 mounted thereon, and a front panel 22 constructed for the manual insertion of data, as well as the presentation in visible form, of, for example, instructions and/or the results of calculations effected within the machine.    For this purpose, the front panel 22 of the scale is provided with a plurality of keys 23 of conventional nature enabling the entry of data relating to a package resting on the platform 21, such

5.

0018116

as the class of mailing to be effected, whether the package is to go by postage or parcel service, and a code such as a "Zip" code indicative of the destination zone of the package. The front panel is also provided with a display window 24 for the display of numeric and/or alphanumeric information, such as the data entered by the operator on the keyboard, requests originating in the device for further information, and the display of calculation results. It will also be apparent that the outputs of the weighing scale 20 may, if desired, be applied by way of a conventional transmission path (not shown) to a postage meter, for direct control of the entry of postage in the postage meter.

Systems of the above type are generally known, so that the details of such systems need not be discussed further herein, it being noted, for example, that sytems of this type are disclosed in U.S. Patent No. 3 635 297, Salava; and U.S. Patent No. 3 951 221, Rock.

It is well-known that postal charges and the like vary from time to time, and are also dependent upon other variables, such as the point of mailing. While the changes in rates, for example, may not occur frequently, when they do occur a very large number of pieces of equipment must be brought up-to-date in a very short period of time. This of course makes it undesirable to use experienced personnel for this purpose, and accordingly the required change-overs of the apparatus should be capable of being performed by inexperienced personnel.

0018116

With a view·to avoiding problems in such change-overs, the housing 20 is provided with a hinged panel 25 enabling access by the user to an internal compartment of the device.   The hinged panel 25 is preferably on the front of the device, conveniently below the front panel, so that it can extend longitudinally across the front of the scale.   This enables the ready replacement of one or more selected present circuit cards of small dimension, as will be discussed in the following paragraphs, so that the look-up tables stored in the scale may be readily changed.

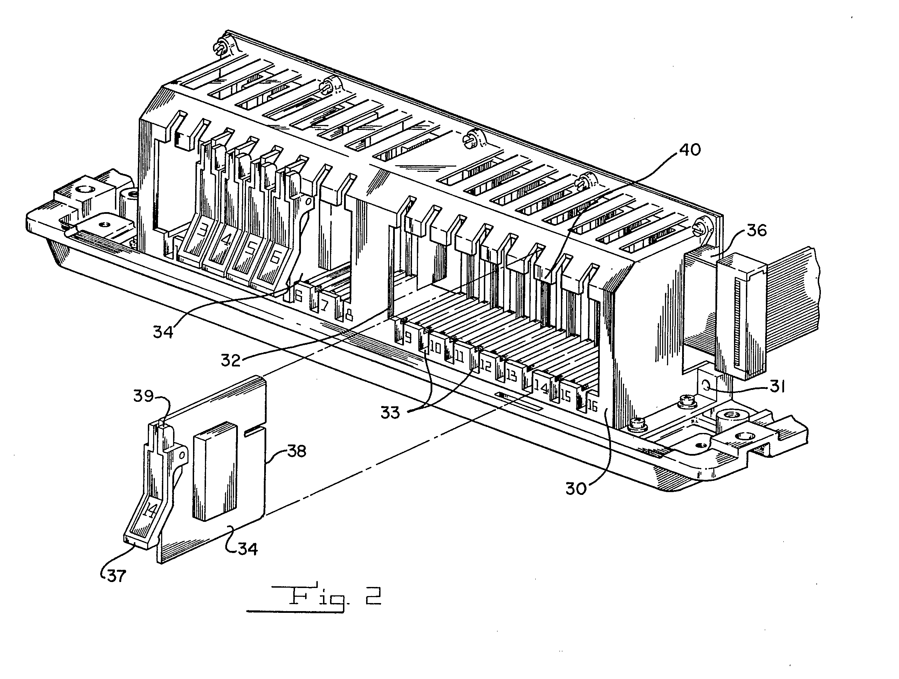

' Referring now to Figure 2, therein is illustrated a view of a rack which may be provided within the front compartment of the scale of Figure 1, accessable behind the hinged panel 25.   The rack 30 may be formed as a unitary element from a suitable plastics material, with mounting holes (indicated at 31) for affixing the rack within the scale compartment by conventional means.   The front of the rack 30 has a number of relatively large sized apertures 32, with aligned printed circuit card receiving slots 33 extending rearwardly from the front of the rack for receiving and guiding a plurality of separate printed circuit cards 34.

The slots 33 are regularly spaced apart preferably throughout the width of the rack, in order to guide the required number of printed circuit cards, in separate parallel vertical planes, so that the contacts thereof can be received by a suitable socket assembly 36 mounted in the compartment of the scale at the rear of the rack 30.

7.  0018116

As will be discussed in the following paragraphs, each of the printed circuit cards has mounted thereon a read only memory (ROM) circuit, preferably in the form of a dual-in line package (DIP), whereby a user may selectively replace the ROM on any of the printed circuit cards, with a minimum of skill, by replacing the whole card. The replacement of the printed circuits cards, in order to effect changes in the look-up tables of the scale, thereby merely requires the opening of the hinged panel 25, the pulling out of the required printed circuit card or cards 34, and the substitution of the removed card or cards by updated versions thereof. The handling of delicate DIP circuits directly is thereby obviated as these are not removed from their cards and the replacement of the required table or tables can be done by unskilled personnel with relative assurance of correctness. Further, since a number of relatively small printed circuit cards are provided, the cost of updating the scale when only minor changes are made in postage rates or the like is minimized, since only one replacement may be necessary, for example, for a minor change in one table.

In addition, in order to further simplify the removal of the printed circuit cards, each card may be provided with a lever 37 hinged to the front edge thereof; i.e., the edge opposite the rear contact bearing edge 38. The hinged lever 37 may have a surface 39 engageable with the front surface 40 of the rack 30 to enable the card to be readily levered out by pulling on the end 37 of the lever.

8.

0018116

Figures 3 - 7 illustrate one example of a printed circuit card 34 in accordance with the invention. The card 34 comprises an insulating board 41 that is preferably substantially square. This shape enables the card to be small so that it does not require a much greater height at the front of the weighing scale for insertion thereof, and yet also does not necessitate the provision of too deep a compartment in the front of the scale for receiving the cards. As an example, the board 41 may be approximately 2 inches square. On the rear edge 38 of the board 41, a plurality of contacts 42 are provided. In a conventional manner, the contacts on the two sides of the board are aligned so that a slot 43 may be provided extending transversely of the board between adjacent contacts, for inhibiting inverted insertion of the card. It is apparent, of course, that a suitable projection must be provided in the socket assembly, cooperating with the slot 43, to insure proper insertion of the printed circuit board. As above discussed, a lever 37 may be hinged to the edge 46 of the board opposite the edge 38, the lever 37 cooperating with the front of the rack as above discussed to enable the ready and simple substitution of printed circuit cards. Suitable indicia, as illustrated in Figures 2, 3 and 5, are preferably provided on the surface of the lever 37 facing the front of the weighing scale, to simplify the location of the correct slot for insertion of the printed circuit card. For example the indicia may be in the form of a numeral corresponding to the identifying numeral of the slot, with the slots of the rack being correspondingly numbered. Alternatively, the function of the data on the look-up table of the card may be identified by suitable indicia on the front of the lever 37, to enable the user to know which of the printing

0018116

circuits should be replaced.

Each of the cards is also provided with an integrated circuit, preferably in the form of a dual-in-line package (DIP) read only memory (ROM) 50.   It will of course be understood that the read only memory may be a PROM, which may be of the erasable type.

Each printed circuit card preferably is provided only with a single DIP, further in order to minimize the cost of replacement of the printed circuit cards, so that a minor change in one or a few tables to be stored in the weighing system need not require the replacement of all of the tables. Thus, each, or at least a number of the individual printed circuit cards may have information stored thereon relating to a particular postal chart, for example, an international postal rate chart.   Another example:  a printed circuit card may correspond to United States Postal Service mailing classes (i.e., first class, third class, priority, etcetera) to enable the determination of the basic rate for packages of the weight determined by the weighing portions of the scale, whereas others of the printed circuit cards may relate solely to other factors, such as (in the United States of America Postal  System) zip to zone conversion.   This feature minimizes the replacements of the cards, as above discussed.

In addition, each printed circuit card has suitable conductors 51 extending from the different contacts 42 and soldered to the terminals of the DIP.   This relatively permanent affixing of the DIP's to the printed circuit cards inhibits the removal of the

10.

0018116

DIP's from the cards by unskilled personnel.    This further minimizes errors that can be made in the replacement of the cards.


It is noted that the guide surfaces of the rack 30 illustrated in Figure 2 are in the form of guide slots 33 adapted to receive the upper and lower edges of the printed circuit cards 34.    It is preferred that the conductors 51 of the individual cards be spaced from the top and bottom edges of the cards so that the portions of the cards which may engage to guide slots 33, do not contact the conductors, in order to prevent damage to printed circuit conductors.


In some instances look-up tables are so complex that the provision of more than one card to store the required information may be necessary.    This may be true, for example, with respect to zip to zone conversions.    Such data is not expected to be normally changed, but alteration thereof may be necessary, for example, if the apparatus is to be moved from one location to another.    In this case, several, e.g. three, of the printed circuit cards may need to be replaced at one time.    Preferably, in order to avoid confusion and errors in the event of such replacement, the cards associated with this data will be insertable in adjacent guide slots in the rack, but the slots 43 in the different cards in the given set, for one mailing location, will be at different levels, whereby incorrect insertion of the cards associated with this function, will be prevented.    This feature is illustrated generally in Figure  8.

While the invention has been disclosed with reference to a single embodiment, it will be apparent that changes may be made therein, and it is not intended that the invention be limited to the details of the illustrated embodiment.

CLAIMS

1.    A user exchangeable postal data memory for a postal weighing scale comprising a printed circuit card characterised in that it has a pair of parallel guide edges joined by and substantially perpendicular to a contact edge (38), spaced apart parallel conductive contacts (42) extending on at least one surface of said card from said contact edge, and an integrated circuit read only memory (50) mounted on said card, conductive means (51) on at least one surface of said card for connecting said memory to said contacts, a lever element (37) pivoted to said card adjacent the edge (46) thereof opposite said contact edge, said lever element having a width greater than the thicknesss of said card, and in a manner known per se, at least one slot (43) in said card extending between a pair of adjacent contacts at said contact edge.

2.    The memory of claim 1 wherein said card is rectilinear.

3.    The memory of claim 1 or 2 wherein the surfaces of said card adjacent said guide edges are free of conductive material.

4.    The memory of claim 1, 2 or 3 wherein only a single slot extends from said contact edge.

5.    The memory of any preceding claim wherein said card has mounted thereon only a single integrated circuit element with the terminals thereof being connnected to said contacts.

0018116

6. The memory of any preceding claim wherein said read only memory comprises a DIP soldered to said card, said DIP being the sole electrical element mounted on said card.

7. A user exchangeable postal data memory for a postal weighing scale comprising a set of printed circuit cards of substantially identical size each being in accordance with any one of claims 1 -6, the slots of the different cards of said set extending between relatively differently located pairs of adjacent contacts.

8. A user changeable table memory for a postal weighing scale, characterised by a substantially square printed board having a separate row of printed circuit contacts along each side at one edge thereof, a transverse slit between a pair of contacts at said one edge, a single DIP ROM mounted on said board, printed circuit conductors on both sides of said board selectively extending from said contacts and soldered directly to the terminals of said ROM, said single ROM constituting the only circuit component on said printed circuit board connected to said contacts, and a pull-out lever having visible locating data thereon and pivoted to the printed circuit board at the edge opposite said one edge.

9. The memory of claim 8 wherein said ROM has data stored therein corresponding solely to a single determined mailing class.

10. The memory of claim 8 wherein said ROM has data stored thereon relating solely to the basic weight-postage conversion in a single determined mailing class and zone.

Fig. 1

Fig. 2

Fig. 3

Fig. 5

Fig. 4

Fig. 6

Fig. 7

Fig. 8

**EUROPEAN SEARCH REPORT**

0018116

EP 80 30 0985

| Category | DOCUMENTS CONSIDERED TO BE RELEVANT | | CLASSIFICATION OF THE APPLICATION (Int. Cl. ⁴) |
|---|---|---|---|
| | Citation of document with indication, where appropriate, of relevant passages | Relevant to claim | |
| D | US - A - 4 084 242 (J.A. CONTI)<br>* Abstract; column 1, lines 17-68; figures * | 1,2,<br>9,10 | G 01 G 19/00<br>H 01 R 23/70<br>G 11 C 17/00 |
| | US - A - 3 675 083 (D.A. WHITE)<br>* Abstract; figures * | 1-3,<br>7,8 | |
| | US - A - 3 702 464 (P.P. CASTRUCCI)<br>* Abstract; figures; column 3, line 35 to column 5, line 4 * | 1-3,5,<br>8 | TECHNICAL FIELDS SEARCHED (Int.Cl. ³)<br><br>G 01 G 19/00<br>G 07 B 17/00<br>17/02<br>17/04<br>B 07 C 1/00<br>H 01 R 23/70<br>G 11 C 17/00<br>G 06 K 19/06 |
| | FR - A - 2 259 510 (CIT-ALCATEL)<br>* Claims and figure * | 1,2,8 | |
| A | DE - A - 1 465 214 (SCANBE)<br>* Claims and figure * | 1,2 | |
| A | US - A - 3 637 994 (J.K. ELLINGBOE)<br>* Abstract and figures * | 1-3 | |

CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 05-08-1980 | DAVID |

EPO Form 1503.1 06.78